# EUROPÄISCHE PATENTSCHRIFT

(11) **EP 0 449 858 B1**
(45) Veröffentlichungstag und Bekanntmachung des Hinweises auf die Patenterteilung: **05.05.1993**
(21) Anmeldenummer: 90900056.4
(22) Anmeldetag: 06.12.1989
(51) Int. Cl.: H01L 27/092

(54) **HOCHSPANNUNGSTRANSISTOR-ANORDNUNG IN CMOS-TECHNOLOGIE**
HIGH-VOLTAGE TRANSISTOR ARRANGEMENT PRODUCED BY CMOS TECHNOLOGY
TRANSISTOR HAUTE TENSION OBTENU PAR TECHNIQUE CMOS

(30) Priorität: 23.12.1988 DE 3843644
(43) Veröffentlichungstag der Anmeldung: 09.10.1991
(73) Patentinhaber: FRAUNHOFER-GESELLSCHAFT ZUR FÖRDERUNG DER ANGEWANDTEN FORSCHUNG E.V., 80636 München (DE)
(72) Erfinder: ZIMMER, Günter, D-4100 Duisburg 29 (DE); ROTH, Walter, D-4600 Dortmund 72 (DE); SELIGER, Siegfried, D-4600 Dortmund 30 (DE); DE WINTER, Rudi, B-3550 Heusden-Zolder (BE)
(86) Internationale Anmeldenummer: DE8900756
(87) Internationale Veröffentlichungsnummer: WO9007794

(56) Entgegenhaltungen:
- EP-A- 0 148 342
- EP-A- 0 160 183
- EP-A- 0 179 693
- DE-A- 3 121 224
- GB-A- 2 028 581

## Beschreibung

### Technisches Gebiet

Die Erfindung bezieht sich auf eine Hochspannungstransistor-Anordnung in CMOS-Technologie (complementary metal oxide semiconductor), gemäß dem Oberbegriff des Anspruchs 1. Anordnungen in dieser Technologie, bei welchen in einem Halbleiter-Substrat. neben den Hochspannungstransistoren sowohl N-Kanal-als auch P-Kanal-MOS-Niederspannungstransistoren integriert sind, zeichnen sich durch hohe Integrationsdichte, hohe Verarbeitungsgeschwindigkeiten und geringe Verlustleistung aus.

Um in einem üblicherweise schwach-dotierten Halbleitersubstrat eines ersten Leitungstyps neben Transistoren mit stark-dotierten Drain- und Sourcezonen des zweiten Leitungstyps auch Transistoren mit stark-dotierten Drain- und Sourcezonen des ersten Leitungstyps integrieren zu können, sind um diese Zonen als Wannen ausgebildete Bereiche der zweiten Leitfähigkeit in das Substrat eingelagert. Solche Standard-CMOS-Prozesse für hochintegrierte Schaltungen (VLSI) werden z. B. in einem Buch von G. Zimmer, CMOS-Technologie, Oldenburg 1982, beschrieben.

Die Dotierungen des Substrats und der Wanne sowie die Eindringtiefe der Wanne in das Substrat und die Eindringtiefe der Drain- und Sourcegebiete der Transistoren sind bei für die Hochintegration geeigneten CMOS-Technologien so bemessen, daß die Durchbruchspannung der Transistoren je nach Anwendung bis ca. 8 Volt bei reinen Digitalanwendungen und bis ca. 15 V bei gemischten Analog-Digital-Anwendungen oder reinen Analoganwendungen reicht.

Für viele Anwendungen ist es wünschenswert Schaltungen einzusetzen, die die Vorteile der CMOS-Technologie aufweisen aber höheren Spannungen standhalten.

Um höhere Spannungsfestigkeit als bei den für die Hochintegration geeigneten und verwendeten CMOS-Technologien realisieren zu können, stehen zwei Wege offen.

Entweder die Verwendung größerer Strukturen der Transistorelemente mit höheren Eindringtiefen, sowie niedrigerer Dotierung von Substrat und Wanne, wodurch die Raumladungszonen größer werden und die Transistoren in größerem Abstand voneinander plaziert werden müssen. Eine solche Technologie eignet sich nicht für die Hochintegration. Oder der Aufbau der Transistoren muß mit zusätzlichen Lithographie- und Prozeßschritten modifiziert werden, wodurch die Herstellung der Schaltungen aufwendiger und teuerer wird.

### Stand der Technik

Mit der Offenlegungsschrift DE 29 40 954 ist ein Verfahren zur Herstellung von Hochspannungs-MOS-Transistoren enthaltenden MOS-integrierten Schaltkreisen bekannt geworden, das es gestattet, komplementäre Transistoren (CMOS-Transistoren) herzustellen.

Bei diesem Verfahren werden die von der CMOS-Technologie üblichen Transistoren mit zusätzlichen Prozeßschritten modifiziert. Zur Herstellung z. B. eines n-Kanal Hochspannungstransistors in einem p-Substrat werden nach der bekannten DMOS-Technologie (double diffused MOS) zwei zusätzliche Zonen in das Substrat eingebracht, wobei eine p-leitende Zone die n⁺-leitende Source-Zone und eine n-leitende Zone die n⁺-leitende Drainzone des Transistors umgibt. Durch das zwischen der eingebrachten p-leitenden und der eingebrachten n-leitenden Zone stehengebliebene Gebiet des p⁻-leitenden Halbleitersubstrates wird eine Driftzone für den n-Kanal-Hochspannungstransistor gebildet. Die n-leitende Zone wirkt als Pinchwiderstand, wodurch ein Durchbruch des Transistors erst bei höheren Spannungen auftritt.

Bei der Herstellung eines solchen Transistors sind zusätzliche Maskierungsschritte ein Dotier- und ein Nachdiffusionsschritt zu den Prozeßschritten eines üblichen CMOS-Prozesses erforderlich.

Ein Hochspannungstransistor, bei welchem nur die Sourcezone mit einer wannenförmigen n-leitenden Zone, die Drainzone dagegen unmittelbar vom Substrat umgeben ist, ist in der EP-A-0 160 183 angegeben. Bei einer solchen Anordnung ist die maximal zu verarbeitende Spannung durch das Feldstärkemaximum am drainseitigen pn-Übergang begrenzt.

In der EP-A-0 148 342 wird ein Verfahren zum gleichzeitigen Herstellen von schnellen Kurzkanal- und spannungsfesten MOS-Transistoren beschrieben. Durch eine ganzflächige Implantation von Bor-Ionen wird eine Dotierung der Kanalzonen der Transistoren derart vorgenommen, daß eine möglichst symmetrische Einsatzspannung erreicht wird.

In der deutschen Offenlegungsschrift DE-A-31 21 224 ist ein MOS-Halbleiterbauelement für hohe Betriebsspannungen beschrieben. Wie bei dem in der DE-A-29 40 954 beschriebenem Transistor sind zwei zusätzliche Zonen in das Substrat eingebracht, wobei eine p-leitende Zone die n⁺-leitende Source-Zone und eine n-leitende Zone die n⁺-leitende Drainzone umgibt. In diesem Fall ist jedoch die als Pinchwiderstand wirkende n-leitende Zone nahe an die p-leitende Zone herangeführt, so daß eine wesentlich schmalere Driftzone für den n-Kanal-Hochspannungstransistor gebildet wird.

### Darstellung der Erfindung

Der Erfindung liegt die Aufgabe zugrunde, eine gattungsgemäße Transistoranordnung so weiterzubilden, daß ein Transistor bereitgestellt wird, der eine wesentlich höhere Durchbruchsspannung aufweist, als herkömmliche CMOS-Transistoren, und der ohne zusätzliche Prozeßschritte mit Hilfe des Standard-CMOS-Prozesses hergestellt werden kann.

Diese Aufgabe wird bei einer gattungsgemäßen Anordnng durch die kennzeichnenden Merkmale des Anspruchs 1 gelöst. Erfindungsgemäß wird ein Bereich der Kanalzone so dotiert, daß er denselben Leitungstyp wie das Substrat, aber eine höhere Dotierung aufweist. Die Implantation erfolgt derart, daß nur ein Teil der Kanalzone, von der Sourcezone ausgehend, höher dotiert wird, so daß im Bereich der verbleibenden Lücke zwischen dem höher dotierten Bereich und der Drainzone das niedrigdotierte Substrat bis an die Oberfläche heranreicht. Dadurch kann sich die Raumladungszone am drainseitigen pn-Übergang in beide Richtungen ausdehnen, so daß das Feldstärkemaximum erniedrigt und somit die Durchbruchspannung des Transistors erhöht wird. Weiterbildungen der Erfindung sind in den Unteransprüchen gekennzeichnet.

Für manche Anwendungen ist es vorteilhaft, den höher dotierten Bereich der Kanalzone bis an die Driftzone heranreichen zu lassen. Mit zunehmender Dotierungskonzentration kann die Schwellenspannung des Transistors angehoben werden. Die Dotierung wird durch Implantation, der sogenannten Schwellenimplantation vorgenommen.

Bei einer erfindungsgemäßen Anordnung ist beispielsweise ein n-Kanal Hochspannungstransistor in einem p-dotierten Halbleitersubstrat wie ein normaler NMOS-Niederspannungstransistor ausgebildet, dessen Drainzone zusätzlich mit einer n-dotierten Driftzone umgeben ist. Da in der Standard-CMOSTechnologie ohnehin Prozeßschritte vorgesehen sind, die zur Ausbildung von n-Wannen für die Einbettung der komplementären PMOS-Transistoren dienen, kann die Driftzone mit den selben Prozeßschritten ausgebildet werden, wie die Wannen. Wie in Anspruch 2 gekennzeichnet, kann damit die Hochspannungstransistoranordnung ohne zusätzliche Prozeßschritte während des Standard-CMOS-Prozesses hergestellt werden.

Im Anspruch 3 ist eine vorteilhafte Weiterbildung der Erfindung gekennzeichnet. Um die Spannungsfestigkeit einer integrierten Schaltung mit erfindungsgemäßen Transistor-Anordnungen zu erhöhen, sind die Transistoren zur Vermeidung von parasitären Stromkanälen durch Feldimplantations-Zonen entkoppelt. Diese dotierten Zonen werden durch Ionenimplantation hergestellt.

Die mit der Erfindung erzielten Vorteile bestehen insbesondere darin, daß in einem Spannungsbereich von über 20 V, in welchem Schaltungen der Standard-CMOS-Technologie nicht eingesetzt werden können, Transistoren zur Verfügung gestellt werden, die mit dem Standard-CMOS-Prozeß herstellbar sind. Damit entfallen zusätzliche Prozeßschritte, die bisher zur Herstellung von Hochspannungstransistoren eingesetzt werden mußten.

Die Herstellung integrierter Schaltungen, die Hochspannungstransistoren enthalten, wird durch die erfindungsgemäße Anordnung einfacher und kostengünstiger. Die erfindungsgemäße Vorrichtung eignet sich besonders für Massenanwendungen in der Automobilindustrie und in der Industriesteuerung, wo häufig Spannungen zwischen 24 und 70 V verarbeitet werden müssen.

### Kurze Beschreibung der Zeichnungen:

Nachfolgend wird die Erfindung anhand von 5 Zeichnungen näher erläutert.

### Es zeigen:

- Figur 1: Aufbau zweier komplementärer Transistoren, in Standard-CMOS-Technologie
- Figur 2: Hochspannungstransistoranordnung gemäß dem Stand der Technik
- Figur 3: Hochspannungstransistoranordnung gemäß dem Stand der Technik
- Figur 4: Meßprotokoll eines Kennlinienfeldes einer erfindungsgemäßen Hochspannungstransistoranordnung
- Figur 5: erfindungsgemäße Hochspannungstransistoranordnung

### Wege zur Ausführung der Erfindung

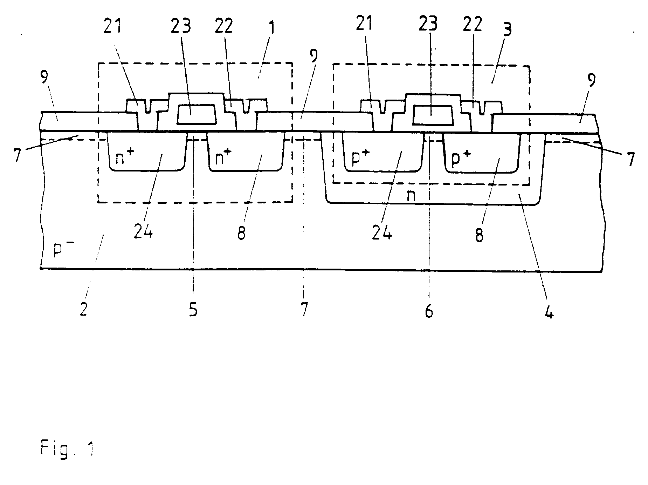

Der Aufbau eines Paares bekannter komplementärer Transistoren 1 und 3, wie sie mit einem Standard-CMOS-Prozeß in N-Wannentechnologie, in einem schwach p-dotierten Substrat 2, hergestellt werden können, ist in Figur 1 dargestellt. Diese Transistoren eignen sich für Anwendungen im Niederspannungsbereich bis maximal ca. 15 V. Sie bestehen aus den Sourcezonen 24 und den Drainzonen 8, die im Fall des NMOS-Transistors 1 eine starke n-Dotierung und im Falle des PMOS-Transistors 3 eine starke p-Dotierung aufweisen. Die Sourcezone 24 und die Drainzone 8 des PMOS-Transistors sind von einem n-dotierten Bereich umgeben, der als N-Wanne 4 bezeichnet wird. Unter dem Feldoxid 9 befinden sich die mit Hilfe der Ionenimplantation hergestellten Bereiche 7, die als Feldimplantation 7 bezeichnet werden und der Vermeidung von parasitären Stromkanälen zwischen den Transistoren dienen. Der leitende Kanal 5 des NMOS-Transistors ist zur Einstellung der Schwellenspannung durch Ionenimplantation p-dotiert. Dabei wird das durch feste Oberflächenladungszustände abgesenkte Leitungsband angehoben. Eine entsprechende Schwellenspannungsimplantation wird auch beim leitenden Kanal 6 des PMOS-Transistors durchgeführt.

In üblicher Weise sind die Sourcekontakte 21, die Drainkontakte 22 und die Gatekontakte 23 angeordnet.

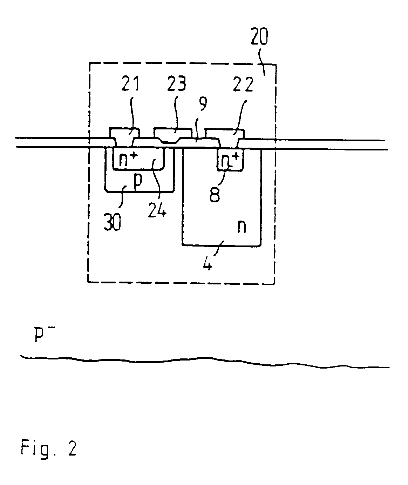

In Figur 2 ist ein Hochspannungstransistor 20 nach dem Stand der Technik dargestellt, der durch zusätzliche Prozeßschritte in CMOS-Technologie hergestellt werden kann. Übereinstimmende Elemente dieses NMOS-Transistors 20 mit dem NMOS-Transistor 1 aus Figur 1 tragen die gleiche Bezeichnung. Die Transistoranordnung 20 weist unterschiedlich dotierte Bereiche 4 und 30 auf, wobei der Bereich 4, der die Drainzone 8 umgibt n-dotiert ist und in einem Prozeßschritt mit den n-Wannen der Niederspannungstransistoren hergestellt wird und der Bereich 30, der die Sourcezone 24 umgibt mit zusätzlichen Prozeßschritten hergestellt werden muß. Diese beiden Bereiche verändern die elektronischen Eigenschaften der Anordnung derart, daß die Durchbruchspannung des Transistors 20 wesentlich höher als bei einem in Figur 1 dargestellten Niederspannungs-NMOS-Transistor 1 liegt. Mit der Anordnung sind Durchbruchspannungen von mehreren hundert Volt erzielbar.

In vielen Fällen ist es erforderlich Spannungen zu verarbeiten, die zwischen den mit Niederspannungstransistoren und den mit Hochspannungstransistoren erreichbaren Spannungen liegen. Der Einsatz von Hochspannungstransistoren ist in diesen Fällen mit unverhältnismäßig hohen Kosten verbunden.

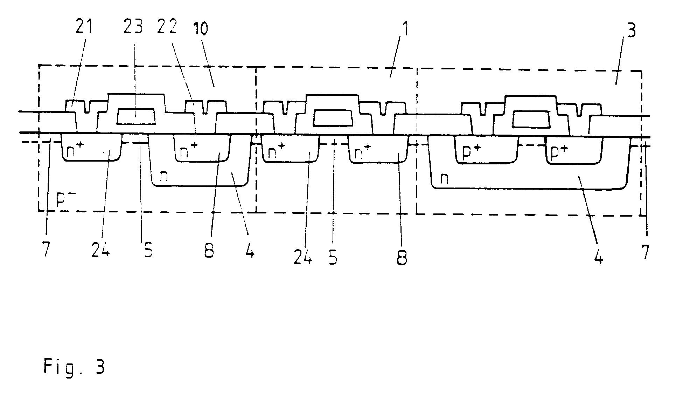

Eine Transistoranordnung 10, die gerade in diesem Zwischenbereich eingesetzt werden kann, ist in Figur 3 gemeinsam mit einem NMOS-Niederspannungstransistor 1 und einem PMOS-Niederspannungstransistor 3 in N-Wannentechnologie abgebildet. Gleiche Bezugsziffern verweisen auf gleiche Elemente der Anordnungen. Der Hochspannungstransistor 10, ist wie ein NMOS-Niederspannungstransistor, jedoch mit einer die Drainzone umschließenden n-Wanne 4 als Driftzone (Pinch-Widerstand) im p-Substrat aufgebaut.

Die Sourcezone 24 des Transistors ist unmittelbar von p-Substrat umgeben. Da die Driftzone 4, welche die Drainzone 8 umgibt gleichzeitig mit der zur Ausbildung der n-Wanne 4 für den Niederspannungstransistor 3 verwendeten Dotierung hergestellt wird, ist der erfindungsgemäße Hochspannungstransistor vollständig mit den Prozeßschritten der Standard-CMOS-Technologie herstellbar. Da er die p-Dotierung für die DMOS-Technologie (nach Fig. 2) nicht aufweist, sind mit diesem Transistor 10 nicht so hohe Durchbruchspannungen wie mit dem Transistor 20 in Figur 2 erzielbar, jedoch reichen die erfindungsgemäßen mit der für die Hochintegration geeigneten CMOS-Technologie erreichbaren Spannungen von mehr als 50 Volt für Anwendungen wie zum Beispiel in der Automobilindustrie oder für Industriesteuerungen aus.

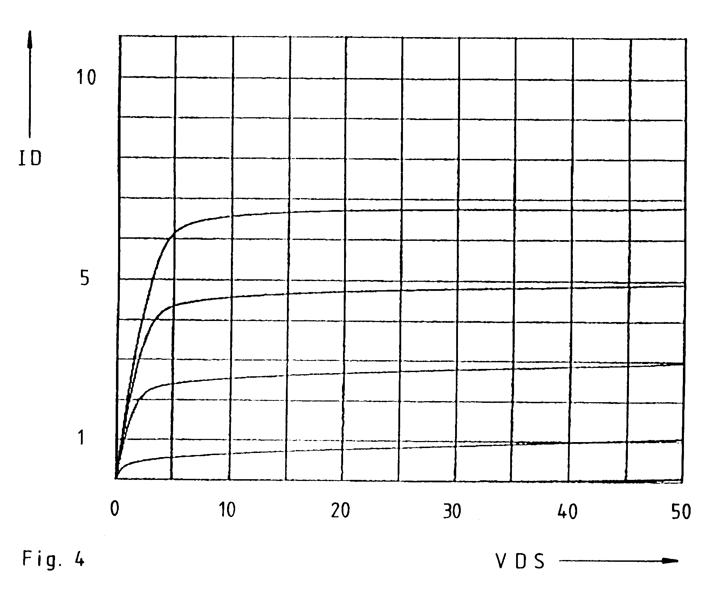

In Figur 4 ist das Kennlinienfeld einer erfindungsgemäßen Anordnung dargestellt. In vertikaler Richtung ist die Größe des Drainstromes ID, in Einheiten von mA in horizontaler Richtung die Drain-Source-Spannung VDS in Volt aufgetragen, wobei eine Einheit 5 Volt darstellt. Bis zu einer Drain-Source-Spannung von 50 V bleibt der Transistor im Sättigungsbereich, so daß die Durchbruchspannung weit oberhalb 50 Volt liegt.

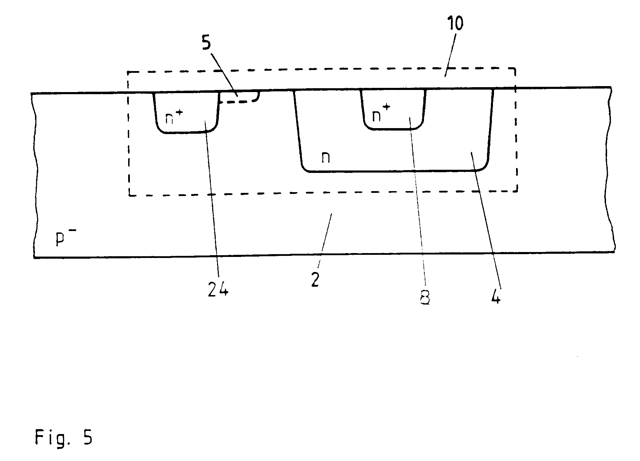

Eine erfindungsgemäße Hochspannungstransistoranordnung ist in Figur 5 dargestellt.

Die leitende Kanalzone 5 ist nur teilweise mit Hilfe der Schwellenimplantation dotiert. Der dotierte Bereich beginnt bei der Sourcezone 24 und endet zwischen der Sourcezone 24 und der die Drainzone 8 umgebenden Driftzone 4. In der dadurch entstehenden Lücke reicht das niedrig dotierte Substrat 2 bis an die Oberfläche heran, wodurch eine Durchbruchspannung von über 100 V erreicht wird. Die Kanalzone 5 wird hergestellt, indem die Maske, die während der Ionenimplantation für die Einstellung der Schwellenspannung des Transistors verwendet wird, so gestaltet wird, daß sie einen Teil des Kanals abdeckt.

Falls für die Schwellenimplantation für NMOS-Transistoren in der Technologie ohnehin eine Maske vorgesehen ist, muß nur diese Maske an der entsprechenden Stelle des Transistors geeignet ausgelegt werden, so daß kein zusätzlicher Prozeßschritt zur Standard-CMOS-Technologie erforderlich ist. Nur in dem Fall, bei dem die Schwellenspannungsimplantationen für die Kanäle 5 und 6 gemeinsam, getrennt von der Feldimplantation 7 ausgeführt werden, ist beim Standardprozeß keine Maske für die Schwellenspannungsimplantation nötig. Bei dieser Variante des Standardprozesses wird eine zusätzliche Maske benötigt, um den Kanal im Bereich der Lücke zwischen Kanalimplantation und Drainzone für den Hochspannungstransistor abzudecken.

Die bisherige Darstellung der Ausführungsbeispiele, die sich auf die n-Wannen-Technologie, in einem p-dotierten Substrat konzentriert, soll keine Beschränkung des allgemeinen Falls darstellen. Mit entsprechender Umkehrung der Dotierungsart erhält man die p-Wannen-Technologie im n-dotierten Substrat.

Die Herstellung der beschriebenen erfindungsgemäßen Transistoranordnungen ist kompatibel sowohl mit der Herstellung von N- und P-Kanal-Niederspannungstransistoren als auch mit der Herstellung von Bipolartransistoren.

## Patentansprüche

1. Hochspannungstransistor-Anordnung in CMOS-Technologie aus einem schwach-dotierten Halbleitersubstrat eines ersten Leitungstyps, mit Transistoren (3) mit stark-dotierten Drain- und Sourcezonen des ersten Leitungstyps, die sich in einer Wanne (4) eines den Substrat entgegengesetzten, zweiten Leitungstyps befinden, und wenigstens einem Transistor (10) mit stark dotierter Drain- und Sourcezone des zweiten Leitungstyps, bei welchem die Drainzone substratseitig von einer Driftzone des zweiten Leitungstyps und die Sourcezone unmittelbar vom Halbleitersubstrat umgeben ist, **dadurch gekennzeichnet,** daß ein Bereich der Kanalzone (5), ausgehend von der Sourcezone (24), mit einer höheren Dotierung desselben Leitungstyps wie das Substrat (2) dotiert ist, der zwischen der Sourcezone (24) und der Driftzone (4) endet, so daß in der verbleibenden Lücke bis zu Driftzone das niedrigdotierte Substrat (2) bis an die Oberfläche heranreicht.

2. Hochspannungstransistor-Anordnung nach Anspruch 1, **dadurch gekennzeichnet,** daß die Driftzone (4) gleichzeitig mit der für die Wanne (4) vorwendeten Dotierung hergestellt ist, so daß kein zusätzlicher Prozeßschritt nötig ist.

3. Hochspannungstransistor-Anordnung nach Anspruch 1 oder 2, **dadurch gekennzeichnet,** daß die Transistoren im Substrat (2) durch Feldimplantations-Zonen (7) entkoppelt sind.

## Claims

1. CMOS technology high-voltage transistor array consisting of a weakly doped semiconductor substrate of a first conductivity type, including transistor (3) having strongly doped drain and source zones of said first conductivity type which are provided in a trough (4) of a second conductivity type opposite to said substrate, and at least one transistor (10) having a strongly doped drain and source zone of said second conductivity type, wherein the drain zone is enclosed, on the substrate side, by a drift zone of said second conductivity type while the source zone is enclosed by said semiconductor substrate directly, **characterized in that,** starting out from said source zone (24), a region of the channel zone (5) presents a stronger doping of the same conductivity type as said substrate (2), which region terminates between said source zone (24) and said drift zone (4), so that the low-doping substrate (2) reachtes up to the surface in the remaining gap up to said drift zone.

2. High-voltage transistor array according to Claim 1, **characterized in that** said drift zone (4) is produced simultaneously with the doping used for said trough (4) so that an additional process step is not required.

3. High-voltage transistor array according to Claim 1 or 2, **characterized in that** the transistors in said substrate (2) are decoupled by field implantation zones (7).

## Revendications

1. Arrangement de transistor H.T. en technologie CMOS, composé d'un substrat semiconducteur à faible dopage d'une première nature de conductivité, comprenant des transistor (3) à zones de drain et de source à fort dopage d'une première nature de conductivité, qui sont prévus dans un creux (4) d'une deuxième nature de conductivité opposée audit substrat, et au moins un transistor (10) à zone de drain et de source à fort dopage de ladite deuxième nature de conductivité, ladite zone de drain étant enfermée, du côté du substrat, par une zone de dérive de la deuxième nature de conductivité et ladite zone de source étant enfermée directement par ledit substrat semiconducteur, **caractérisé en ce** que, provenant de ladite zone de source (24), une région de la zone de canal (5) présente un dopage plus fort de la même nature de conductivité que le substrat, laquelle région se termine entre ladite zone de source (24) et ladite zone de dérive (4) de façon que le substrat à faible dopage (2) s'étend jusqu'à la surface dans l'interstice restant jusqu'à ladite zone de dérive.

2. Arrangement de transistors H.T. selon la revendication 1, **caractérisé en ce** que ladite zone de dérive (4) est fabriqué en même temps au dopage utilisé pour ledit creux (4) de façon qu'une section de processus supplémentaire ne soit nécessaire.

3. Arrangement de transistor H.T. selon la revendication 1 ou 2, **caractérisé en ce** que les transistors dans le substrat (2) sont découplés par des zones d'implantation de champs (7).
